# EUROPEAN PATENT SPECIFICATION

(11) **EP 1 947 547 B1**
(45) Date of publication and mention of the grant of the patent: **26.03.2014**
(21) Application number: 07000828.9
(22) Date of filing: 16.01.2007
(51) Int. Cl.: G06F 1/20

(54) **Detachable fan apparatus for quick maintenance**
Abnehmbares Ventilatorgerät für schnelle Wartung
Appareil de ventilation détachable pour un entretien rapide

(43) Date of publication of application: 23.07.2008
(73) Proprietor: Portwell Inc., Neihu Taipei City 114 (TW)
(72) Inventor: Hung, Te-Fu, Qidu District, Keelung City 206, (TW)
(74) Representative: Zeitler, Giselher

(56) References cited:
- US-A- 6 040 981
- US-A- 6 110 245
- US-A1- 2006 256 522

## Description

### BACKGROUND OF THE INVENTION

### Field of the Invention

The present invention relates to a computer casing comprising a detachable fan apparatus for quick maintenance, and more particularly to a fan apparatus that can be swapped by engaging and pressing said computer casing with pivotal holes and axial rods of a frame and stopping pillars with a stopping plate, such that when it is necessary to change a filter on the frame, users simply incline the frame outward to a specific angle without removing the whole frame from the computer casing to achieve the swapping effect.

### Description of the Related Art

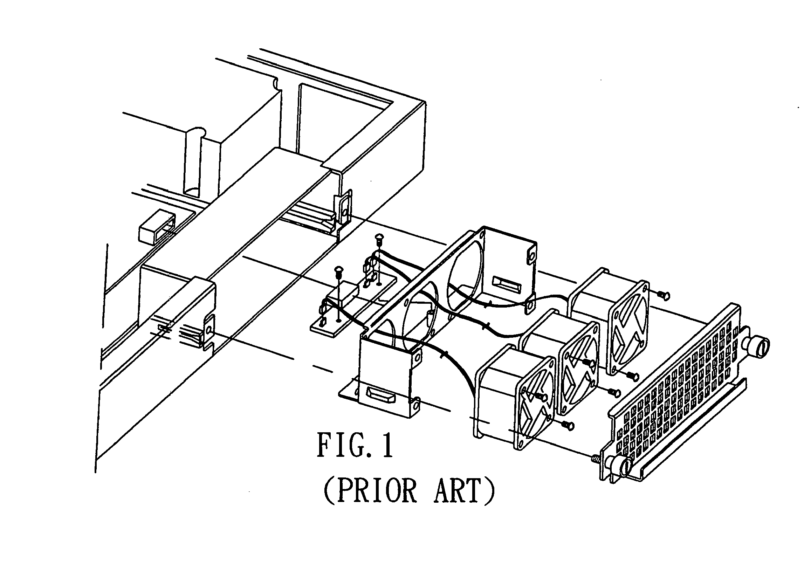

Referring to FIG. 1 for a detachable fan apparatus as disclosed in R.O.C. Pat. No. TWM252258 U, the apparatus includes a casing, a guide track fixing frame disposed at a specific position of the casing, a sliding guide track disposed separately on both sides of the geode track fixing frame, a fan having a shape corresponding to the guide track fixing frame and mounted onto the guide track fixing frame, an embedding body separately disposed on both sides of the fan fixing frame and corresponding to the slide guiding track, so that the fan fixing frame is movable back and forth in the guide track fixing frame, and the fan fixing frame installs at least one heat dissipating fan, and the fan fixing frame also includes an electric plug pluggable into its corresponding electric socket.

When the fan apparatus of this structure is used, the electric plug is plugged into the electric socket and electrically connected with the electric socket in the casing and then embedded into a guide track fixing frame of the fan fixing frame for mounting and fixing the heat dissipating fan of the casing. On the other hand, if it is necessary to remove the apparatus, the fan fixing frame is moved outward along the sliding guide track to separate the heat dissipating fan from the casing. However, the fan apparatus of this structure still has the following drawbacks.
1. Impedance will be produced easily by the electric connection through the electric plug.
2. If it is necessary to remove the apparatus, the screws are loosened to move the fan fixing frame outward along the sliding guide track, and the filter is removed from the surface of the fan. Users have to stop the operation of the fan to remove the fan fixing frame completely from the casing for a swap. According to statistics, such arrangement is designed mostly for a change of filter only, but not for the purpose of repairing the fan. Therefore, such arrangement definitely cannot meet user requirements.

According to document US 2006/256 522 A1 a conventional fan tray includes a series of fan modules removably coupled to the fan tray. The fan tray may include guides that form a slot into which the fan module can be inserted. The fan tray is designed as a kind of a box having a rear panel and side faces. Said fan tray with its backside is pivotally connected to the opening. Furthermore, the rear panel of said fan tray is abutted to the chassis at its first position. The fan tray is installed in the outer area of the bottom of the chassis. The rear panel of said fan tray may not seal the chassis because the upper surface of the fan tray is an open area with channels. For sealing purposes of the chassis a further U-formed plate is provided above said fan tray. This plate above the fan tray seals the chassis.

### Summary of the Invention

In view of the shortcomings of the aforementioned conventional detachable heat dissipating fan, the inventor of the present invention based on years of experience in the related industry to conduct extensive researches and experiments, and finally developed a computer casing comprising a detachable fan apparatus for quick maintenance in accordance with claim 1 of the present invention.

Further embodiments are mentioned in the sub-claims. Therefore, it is a primary objective of the present invention to provide a detachable fan apparatus for quick maintenance adapted to be installed to the computer casing, and the computer casing includes at least one opening disposed on a surface of the computer casing, and both sides of the opening separately have a pivotal hole, pivotally connected to a frame. The frame installs at least one fan, and a gap is maintained between the fan and the frame for installing a filter, so that an end without the axial rod of the frame can be secured onto the computer casing, and the frame can be fixed onto a surface of the computer casing. If it is necessary to change the filter, a secured end of the frame is separated from the computer casing, and the frame is turned outward until the stopping plate is pressed onto the stopping pillar by means of the pivotal hole and the axial rod, so that the frame is inclined to a predetermined angle for the change of filter, and a convenient use without the need of stopping the operation of the fan or removing the frame can be achieved.

According to the present invention a detachable fan apparatus for quick maintenance is provided, wherein the stopping pillar is disposed proximate to the opening of the computer casing and corresponding to a stopping plate of the frame, such that when the frame is turned outward, the stopping pillar and the stopping plate are pressed with each other to drive the frame to incline to a predetermined angle.

A further objective of the present invention is to provide a detachable fan apparatus for quick maintenance, wherein the fan is connected with the computer casing by the electric circuit, so that when the frame is turned outward for changing a filter, the fan can continue its operation for a convenient use of the fan.

To make it easier for our examiner to understand the present invention, the following embodiment accompanied with the related drawings are described in details.

### BRIEF DESCRIPTION OF THE DRAWINGS

FIG. 1 is a schematic view of a conventional fan;
FIG. 2 is a perspective view of the present invention;
FIG 3 is an exploded view of the present invention;
FIG. 4 is a schematic view of an operation of the present invention;
FIG. 5 is a cross-sectional view of closing a frame onto a computer casing in accordance with the present invention; and
FIG. 6 is a cross-sectional view of lifting up and opening a frame in accordance with the present invention.

### DETAILED DESCRIPTION OF THE PREFERRED EMBODIMENTS

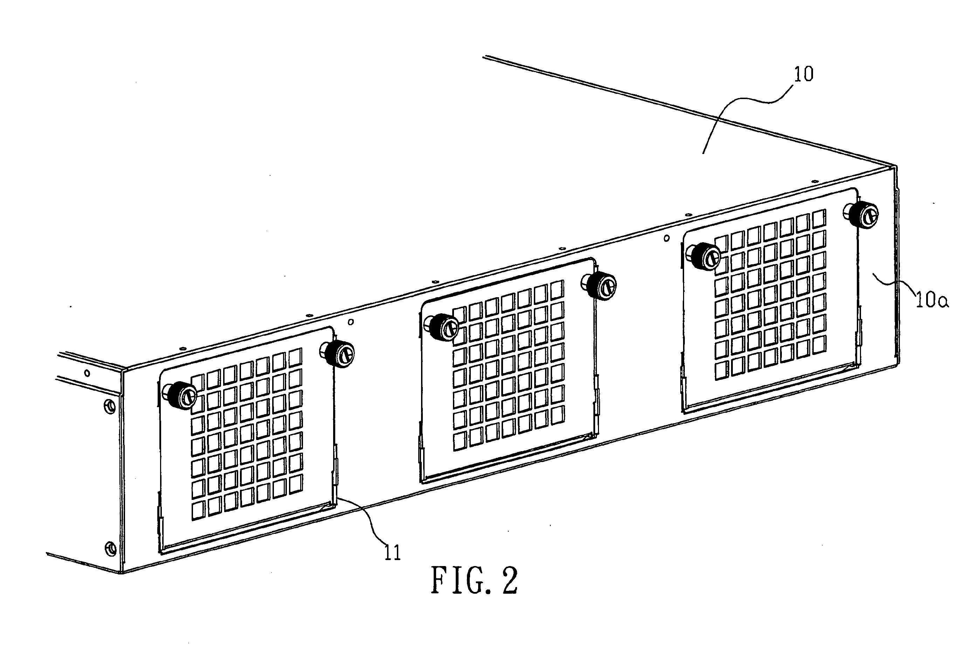

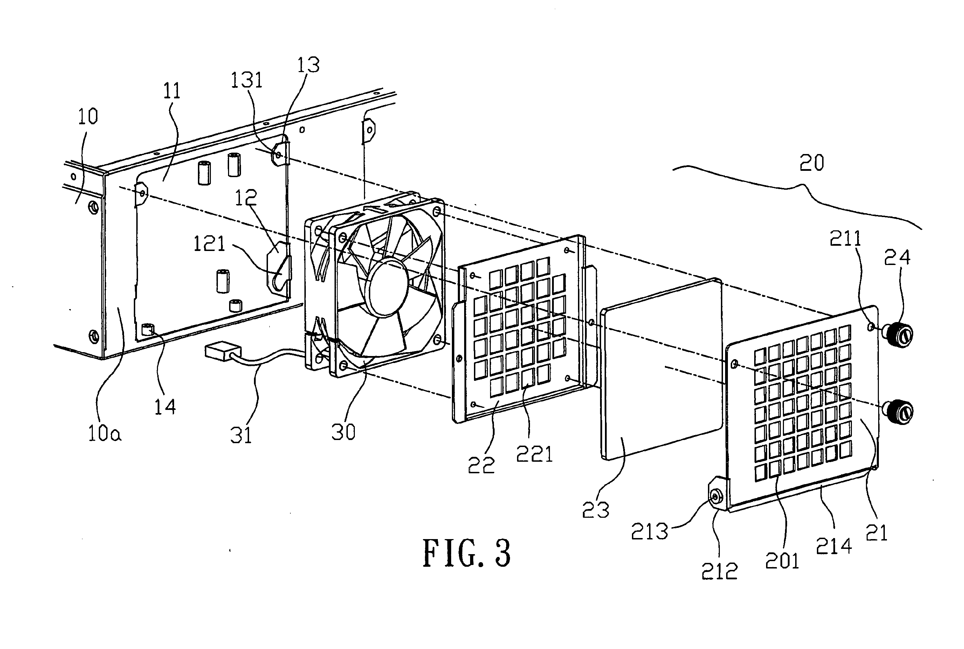

Referring to FIGS. 2 and 3 for a computer casing comprising a detachable fan apparatus for quick maintenance in accordance with the present invention, the fan is installed onto the computer casing 10, and a surface of the computer casing 10a has at least one opening 11 (wherein this embodiment has three openings 11, but the number of openings can vary according to actual requirements), and both sides of the opening 11 separately have a protruding ear 12, and each protruding ear 12 is disposed corresponding to each pivotal hole 121, and the pivotal holes 121 are inclined to a predetermined angle (which is 45 degrees in this embodiment), and both sides of the opening 11 separately include a protruding plate 13, and each protruding plate 13 has a locking hole 131, and the protruding ear 12 and the protruding plate 13 are disposed proximate to distal edges, and the computer casing 10 has a stopping pillar 14 proximate to the opening 11.

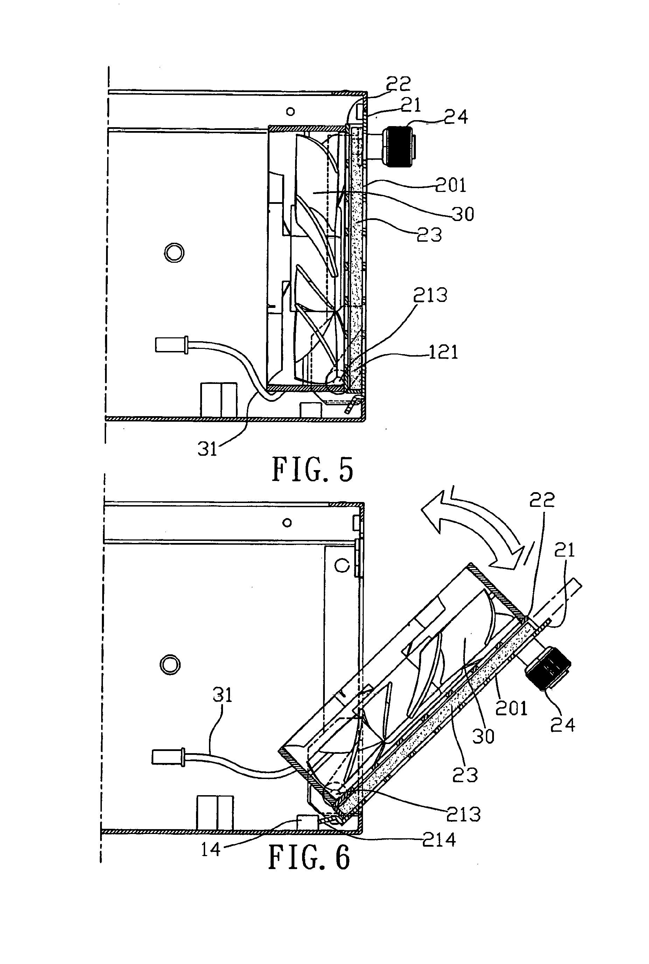

Further, a frame 20 is pivotally connected to the opening 11, and the frame 20 has a rear panel 21, and the rear panel 21 has a plurality of meshes 201, and the rear panel 21 includes a partition 22 with meshes 221 thereon, such that a gap is maintained between the partition 22 and the rear panel 21 for installing a filter 23, and a fan 30 is secured onto the partition 22 and has an electric plug 31 connected to an electric circuit and a power supply in the computer casing 10. Both sides of the rear panel 21 separately have a locking hole 211 for securing a screw rod 24, and the screw rod 24 can be passed through the locking hole 211 and secured onto the locking hole 131. Further, both sides of the rear panel 21 separately have an inwardly curved bent plate 212, and each bent plate 212 has a protruding axial rod 213, and the axial rod 213 is embedded into the pivotal hole 121, such that the rear panel 21 can be pivotally connected to the opening 11. The rear panel 21 has a stopping plate 214, such that if the stopping plate 214 at the rear panel 21 is turned outward from the opening 11, the stopping plate 214 will press on the stopping pillar 14 to erect the rear panel 21 at its position (as shown in FIG 6).

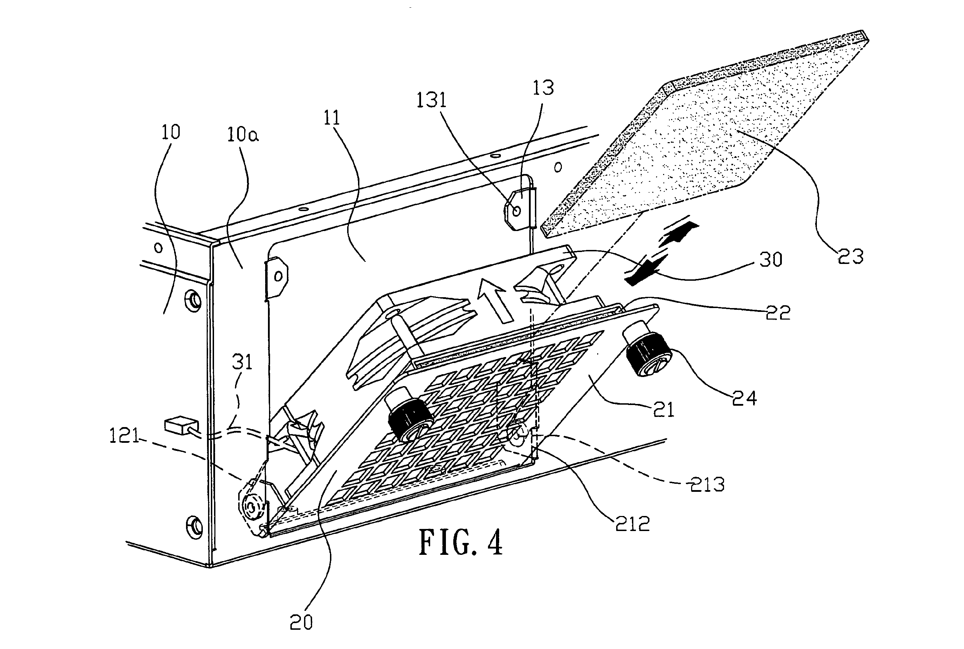

When the fan apparatus is used as shown in FIGS. 4 to 6, the axial rods 213 are embedded into the pivotal holes 121 respectively, such that the rear panel 21 is pivotally connected to the opening 11 to seal the opening 11 (as shown in FIG. 5), and the fan 30 can be electrically connected to the electric circuit and a power supply in the computer casing 10. On the other hand, if it is necessary to change a filter 23, a user simply loosens the screw rod 24 to separate the screw rod 24 from the locking hole 131, and turns the frame 20 naturally outward to a specific angle by the inclined pivotal hole 121 to allow the user to conveniently remove and change the filter 23. Such arrangement can achieve the effect of a convenient use without interrupting the operation of the fan or removing the whole frame.

While the invention has been described by way of example and in terms of a preferred embodiment, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures.

## Claims

1. A computer casing comprising:
at least one opening (11) disposed on a surface (10a) of said computer casing (10), a protruding ear (12) disposed separately on both sides of said opening (11), an inclined pivotal hole (121) disposed at each protruding ear (12), and a stopping pillar (14) disposed at a position proximate to said opening (11) of said computer casing (10); and
a detachable fan apparatus for quick maintenance adapted to be installed to said computer casing (10), said apparatus comprising:
- a frame (20) pivotally coupled to said opening (11) of said computer casing (10), and having a rear panel (21) and a partition (22) fixed onto said rear panel (21), wherein a gap is maintained between said partition (22) and said rear panel (21), and a protruding axial rod (213) disposed on both sides of said rear panel (21) and embedded into said inclined pivotal holes (121), such that said rear panel (21) is pivotally connected to said opening (11) to seal said opening (11), and said frame (20) further including a stopping plate (214) disposed corresponding to said stopping pillar (14);
- a filter (23) included between said rear panel (21) and said partition (22); and
- a fan (30) fixed onto a surface of said partition (22);
wherein an end without said axial rods (213) of said frame (20) is adapted to be secured with said computer casing (10) and when it is necessary to change said filter (23), the secured end of said frame (20) is adapted to be separated from said computer casing (10), and said frame (20) is adapted to be turned outward until said stopping plate (214) is pressed onto said stopping pillar (14) by means of said pivotal hole (121) and said axial rod (213) so that said frame (20) is inclined to a predetermined angle for changing the filter (23).

2. Detachable fan apparatus according to claim 1, **characterized in that** each pivotal hole (121) is inclined to a predetermined angle.

3. Detachable fan apparatus according to claim 1 or 2, **characterized in that** said fan (30) is coupled to a power supply in said computer casing (10) directly by an electric circuit.

4. Detachable fan apparatus according to one of claims 1 to 3, **characterized in that** said rear panel (21) and partition (22) have meshes (201; 221) thereon.

## Patentansprüche

1. Computer-Gehäuse, umfassend wenigstens eine Öffnung (11), die auf einer Oberfläche (10a) des Computer-Gehäuses (10) angeordnet ist, eine vorstehende Öse (12), die getrennt auf beiden Seiten der Öffnung (11) liegt, ein schräges Schwenkloch (121), das sich an jeder vorstehenden Öse (12) befindet, und ein Anschlagzapfen (14), der an einer Stelle in der Nähe der Öffnung (11) des Computer-Gehäuses (10) angeordnet ist; und ferner umfassend eine lösbare Gebläse-Vorrichtung zur schnellen Wartung, die so gebaut ist, daß sie in das Computer-Gehäuse (10) installiert werden kann, **gekennzeichnet durch** einen Rahmen (20), der an der Öffnung (11) des Computer-Gehäuses (10) schwenkbar angebracht ist und eine Rückwand (21) sowie eine Trennwand (22) aufweist, die auf der Rückwand (21) befestigt ist, wobei ein Spalt zwischen der Trennwand (22) und der Rückwand (21) beibehalten wird und auf beiden Seiten der Rückwand (21) ein vorstehender axialer Zapfen (213) vorgesehen ist, der in die schrägen Schwenklöcher (121) eingesteckt wird, derart, daß die Rückwand (21) mit der Öffnung (11) schwenkbar verbunden ist, um die Öffnung (11) abzudichten, und wobei der Rahmen (20) des weiteren eine Anschlagplatte (214) aufweist, die entsprechend dem Anschlagzapfen (14) angeordnet ist; ferner **gekennzeichnet durch** einen Filter (23), der zwischen der Rückwand (21) und der Trennwand (22) liegt, und ein Gebläse (30), das auf einer Oberfläche der Trennwand fixiert ist, wobei ein Ende ohne die axialen Zapfen (213) des Rahmens (20) an dem Computer-Gehäuse (10) befestigt werden kann und dann, wenn die Notwendigkeit besteht, den Filter (23) zu wechseln, das befestigte Ende des Rahmens (20) von dem Computer-Gehäuse (10) getrennt werden kann und der Rahmen (20) in der Lage ist, nach außen gedreht zu werden, bis die Anschlagplatte (214) auf den Anschlagzapfen (14) mit Hilfe des Schwenkloches (121) und des axialen Zapfens (213) so gedrückt wird, daß der Rahmen (20) in einem vorbestimmten Winkel geneigt ist, so daß der Filter (23) ausgetauscht werden kann.

2. Lösbare Gebläse-Vorrichtung nach Anspruch 1, **dadurch gekennzeichnet, daß** jedes Schwenkloch (123) in einem vorbestimmten Winkel geneigt ist.

3. Lösbare Gebläse-Vorrichtung nach Anspruch 1 oder 2, **dadurch gekennzeichnet, daß** das Gebläse (30) an eine Stromzufuhr in dem Computer-Gehäuse (10) direkt mit einem elektrischen Schaltkreis verbunden ist.

4. Lösbare Gebläse-Vorrichtung nach einem der Ansprüche 1 bis 3, **dadurch gekennzeichnet, daß** sich auf der Rückwand (21) und der Trennwand (22) Gitter (201, 221) befinden.

## Revendications

1. Boîtier d'ordinateur comprenant :
au moins une ouverture (11) disposée sur une surface (10a) dudit boîtier d'ordinateur (10), une patte en projection (12) disposée séparément sur les deux côtés de ladite ouverture (11), un trou de pivotement incliné (121) disposé dans chaque patte en projection (12),
et un plot d'arrêt (14) disposé à une position à proximité de ladite ouverture (11) dudit boîtier ordinateur (10) ; et
un ventilateur détachable pour une maintenance rapide, adapté à être installé sur ledit boîtier d'ordinateur (10), ledit ventilateur comprenant :
- un cadre (20) couplé en pivotement à ladite ouverture (11) dudit boîtier d'ordinateur (10) et ayant un panneau arrière (21) et une cloison (22) fixée sur ledit panneau arrière (21), dans lequel un intervalle est maintenu entre ladite cloison (22) et ledit panneau arrière (21), et une barre axiale (213) en projection disposée sur les deux côtés dudit panneau arrière (21) et logée dans lesdits trous de pivotement inclinés (121), de telle façon que ledit panneau arrière (21) est connecté en pivotement à ladite ouverture (11) pour fermer ladite ouverture (11) de manière étanche, et ledit cadre (20) inclut en outre une plaque d'arrêt (214) disposée en correspondance dudit plot d'arrêt (14) ;
- un filtre (23) inclus entre ledit panneau arrière (21) et ladite cloison (22) ; et
- un ventilateur (30) fixé sur une surface de ladite cloison (22) ;
dans lequel une extrémité dudit cadre (20) dépourvue desdites barres axiales (213) est adaptée à être fixée avec ledit boîtier d'ordinateur (10) et, lorsqu'il est nécessaire de changer ledit filtre (23), l'extrémité fixée dudit cadre (20) est adaptée à être séparée vis-à-vis dudit boîtier d'ordinateur (10) et ledit cadre (20) est adapté à être tourné vers l'extérieur jusqu'à ce que ladite plaque d'arrêt (214) soit pressée sur ledit plot d'arrêt (14) au moyen dudit trou de pivotement (121) et de ladite barre axiale (213) de sorte que ledit cadre (20) est incliné à un angle prédéterminé pour changer le filtre (23).

2. Ventilateur détachable selon la revendication 1, **caractérisé en ce que** chaque trou de pivotement (121) est incliné d'un angle prédéterminé.

3. Ventilateur détachable selon la revendication 1 ou 2, **caractérisé en ce que** ledit ventilateur (30) est couplé à une alimentation de puissance dans ledit boîtier d'ordinateur (10) directement par un circuit électrique.

4. Ventilateur détachable selon l'une des revendications 1 à 3, **caractérisé en ce que** ledit panneau arrière (21) et ladite cloison (22) comportent sur eux-mêmes des grillages (201 ; 221).
